# EUROPEAN PATENT SPECIFICATION

(11) **EP 3 455 889 B1**
(45) Date of publication and mention of the grant of the patent: **12.02.2020**
(21) Application number: 17722137.1
(22) Date of filing: 27.04.2017
(51) Int. Cl.: H01L 51/54, C09K 11/06

(54) **PHOSPHORESCENT LIGHT-EMITTING COMPLEX AND USE IN LIGHT-EMITTING DEVICE**
PHOSPHORESZIERENDER LICHTEMITTIERENDER KOMPLEX UND VERWENDUNG IN LICHTEMITTIERENDER VORRICHTUNG
COMPLEXE ÉLECTROLUMINESCENT PHOSPHORESCENT ET SON UTILISATION DANS UN DISPOSITIF ÉLECTROLUMINESCENT

(30) Priority: 13.05.2016 GB 201608433
(43) Date of publication of application: 20.03.2019
(73) Proprietor: Cambridge Display Technology Limited, Cardinal Way Godmanchester Cambridgeshire PE29 2XG (GB); Sumitomo Chemical Co., Ltd., Tokyo 104-8260 (JP)
(72) Inventor: TARRAN, William, Godmanchester Cambridgeshire PE29 2XG (GB)
(74) Representative: Gilani, Anwar
(86) International application number: PCT/GB2017/051183
(87) International publication number: WO 2017/194909

(56) References cited:
- JP-A- 2011 253 980
- US-A1- 2015 349 267

## Description

### Field of the Invention

The present invention relates to light-emitting compounds, in particular phosphorescent light-emitting compounds; compositions, solutions and light-emitting devices comprising said light-emitting compounds; and methods of making said light-emitting devices.

### Background of the Invention

Electronic devices containing active organic materials are attracting increasing attention for use in devices such as organic light emitting diodes (OLEDs), organic photoresponsive devices (in particular organic photovoltaic devices and organic photosensors), organic transistors and memory array devices. Devices containing active organic materials offer benefits such as low weight, low power consumption and flexibility. Moreover, use of soluble organic materials allows use of solution processing in device manufacture, for example inkjet printing or spin-coating.

An OLED may comprise a substrate carrying an anode, a cathode and one or more organic light-emitting layers between the anode and cathode.

Holes are injected into the device through the anode and electrons are injected through the cathode during operation of the device. Holes in the highest occupied molecular orbital (HOMO) and electrons in the lowest unoccupied molecular orbital (LUMO) of a light-emitting material combine to form an exciton that releases its energy as light.

Suitable light-emitting materials include small molecule, polymeric and dendrimeric materials. Suitable light-emitting polymers include poly(arylene vinylenes) such as poly(p-phenylene vinylenes) and polyarylenes such as polyfluorenes.

A light emitting layer may comprise a semiconducting host material and a light-emitting dopant wherein energy is transferred from the host material to the light-emitting dopant. For example, J. Appl. Phys. 65, 3610, 1989 discloses a host material doped with a fluorescent light-emitting dopant (that is, a light-emitting material in which light is emitted via decay of a singlet exciton).

Phosphorescent dopants are also known (that is, a light-emitting dopant in which light is emitted via decay of a triplet exciton).

WO 2011/052516, WO 2014/085296, US 2013/221278, JP 2011/253980 and US 2015/0349267 disclose phosphorescent materials containing phenyltriazole ligands.

It is an object of the invention to provide blue phosphorescent light-emitting compounds suitable for use in an OLED.

It is a further object of the invention to provide solution processable blue phosphorescent light-emitting compounds suitable for use in an OLED.

It is a further objection of the invention to provide phosphorescent light-emitting compounds having long operational life when used in an OLED.

### Summary of the Invention

In a first aspect the invention provides a phosphorescent compound of formula (I): 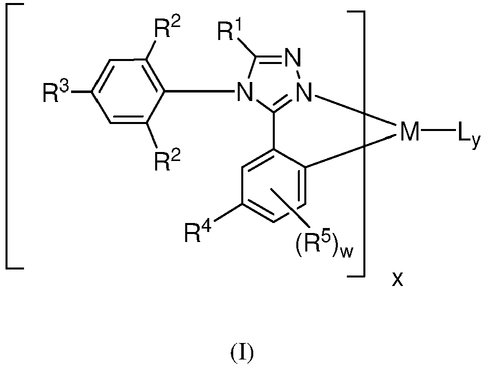 wherein:
M is a transition metal;
L in each occurrence is independently a mono- or poly-dentate ligand;
R¹ in each occurrence is independently a C₄₋₂₀ alkyl comprising at least one tertiary carbon atom;
R² independently in each occurrence is a linear, branched or cyclic C₁₋₂₀ alkyl group
R³ is a linear, branched or cyclic C₁₋₂₀ alkyl group or a group of formula -(Ar¹)ₚ wherein Ar¹ in each occurrence is independently an unsubstituted or substituted aryl or heteroaryl group and p is at least 1;
R⁴ is a group of formula -(Ar²)_{q} wherein Ar² in each occurrence is independently an unsubstituted or substituted aryl or heteroaryl group and q is at least 1;
R⁵ is a substituent;
w is 0 or a positive integer;
x is at least 1; and
y is 0 or a positive integer.

In a second aspect the invention provides a composition comprising a host material and a compound according to the first aspect.

In a third aspect the invention provides a solution comprising a compound or composition according to the first or second aspect dissolved in one or more solvents.

In a fourth aspect the invention provides an organic light-emitting device comprising an anode, a cathode and a light-emitting layer between the anode and cathode wherein the light-emitting layer comprises a compound or composition according to the first or second aspect.

In a fifth aspect the invention provides a method of forming an organic light-emitting device according to the fourth aspect, the method comprising the step of depositing the light-emitting layer over one of the anode and cathode, and depositing the other of the anode and cathode over the light-emitting layer.

### Description of the Drawings

The invention will now be described in more detail with reference to the Figures, in which:

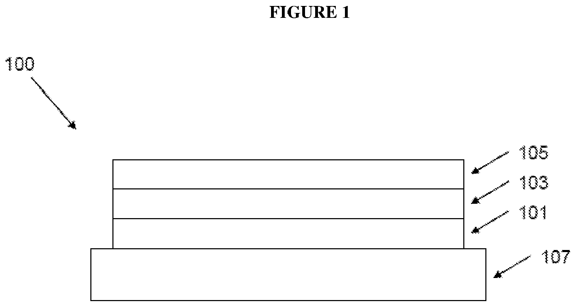

Figure 1 illustrates an OLED according to an embodiment of the invention.

### Detailed Description of the Invention

Figure 1, which is not drawn to any scale, illustrates schematically an OLED 100 according to an embodiment of the invention. The OLED 100 is carried on substrate 107 and comprises an anode 101, a cathode 105 and a light-emitting layer 103 between the anode and the cathode. Further layers (not shown) may be provided between the anode and the cathode including, without limitation, hole-transporting layers, electron-transporting layers, hole-blocking layers, electron-blocking layers, hole-injection layers and electron-injection layers.

Exemplary OLED structures including one or more further layers include the following:
Anode / Hole-injection layer / Light-emitting layer / Cathode
Anode / Hole transporting layer / Light-emitting layer / Cathode
Anode / Hole-injection layer / Hole-transporting layer / Light-emitting layer / Cathode
Anode / Hole-injection layer / Hole-transporting layer / Light-emitting layer / Electron-transporting layer / Cathode.

Light-emitting layer 103 may contain a host material and a phosphorescent compound of formula (I). The host material may combine holes injected from the anode and electrons injected from the cathode to form singlet and triplet excitons. The triplet excitons at least may be transferred to the phosphorescent compound of formula (I), and decay to produce phosphorescence.

The device may contain more than one light-emitting layer. The light-emitting layer or layers may contain the phosphorescent compound of formula (I) and one or more further light-emitting compounds, for example further phosphorescent or fluorescent light-emitting materials having a colour of emission differing from that of the compound of formula (I). Optionally, the device comprises a hole-transporting layer and a further light-emitting material is provided in one or both of the hole-transporting layer and the light-emitting layer containing the phosphorescent compound of formula (I). Emission from the compound of formula (I) and the further light-emitting compounds may produce white light when the device is in use. Optionally, a light-emitting layer comprising a compound of formula (I) consists essentially of the compound of formula (I), one or more host materials and optionally one or more further light-emitting compounds.

Preferably, light emitted from a composition consisting of a host and a compound of formula (I) is substantially all from the compound of formula (I).

### Phosphorescent Compound

Metal M of the phosphorescent compound of formula (I) may be any suitable transition metal, for example a transition metal of the second or third row of the d-block elements (Period 5 and Period 6, respectively, of the Periodic Table). Exemplary metals include Ruthenium, Rhodium, Palladium, Silver, Tungsten, Rhenium, Osmium, Iridium, Platinum and Gold. Preferably, M is iridium.

The compound of formula (I) contains at least one ligand of formula (II):

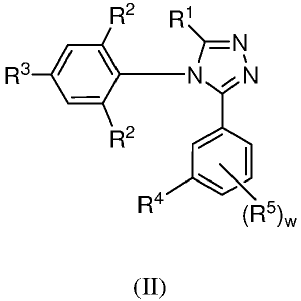

All ligands of the compound of formula (I) may have formula (II) in which case y is 0. In the case where y is 0, x is preferably 3.

In other embodiments, the compound may contain at least one ligand L (y is at least 1) wherein L is a ligand other than a ligand of formula (II). In this case, y may be 1 or 2 and x may be 1 or 2. Exemplary ligands L are bidentate ligands and include, without limitation, O,O cyclometallating ligands, optionally diketonates, optionally acac; N,O cyclometallating ligands, optionally picolinate; and N,N cyclometallating ligands.

R¹ is a C₄₋₂₀ alkyl group, optionally a C₄₋₁₂ alkyl group, comprising at least one tertiary carbon atom.

Preferably, the tertiary carbon atom is bound directly to the triazole group of formula (I).

Optionally, R¹ comprises only one tertiary carbon atom. Optionally, R¹ is selected from *tert-*butyl and neopentyl.

R² independently in each occurrence is a linear, branched or cyclic C₁₋₂₀ alkyl group, optionally C₁₋₁₂ alkyl group, preferably a C₁₋₄ alkyl group, more preferably methyl, ethyl, n-propyl or isopropyl.

R³ is a linear, branched or cyclic C₁₋₁₂ alkyl group or a group of formula -(Ar¹)ₚ wherein Ar¹ in each occurrence is independently an aryl or heteroaryl group and p is at least 1, optionally 1, 2 or 3.

Ar¹ may independently in each occurrence be selected from C₆₋₂₀ aryl, optionally phenyl, and C₃₋₂₀ heteroaryl, optionally a heteroaryl containing 3-20 C atoms and one or more heteroatoms selected from O, S and N.

In the case where p is greater than 1, the group -(Ar¹)ₚ may form a linear or branched chain of Ar¹ groups.

Optionally, substituents of Ar¹, where present, are selected from the group consisting of branched, linear or cyclic C₁₋₂₀ alkyl wherein one or more non-adjacent, non-terminal C atoms of the alkyl group may be replaced with O, S, C=O and -COO-, and wherein one or more H atoms of the C₁₋₂₀ alkyl may be replaced with F. Preferred substituents are selected from branched, linear or cyclic C₁₋₁₀ alkyl.

By "non-terminal carbon atom" as used herein is meant a carbon atom of an alkyl chain other than the carbon atom of a methyl group at the end of a linear alkyl (n-alkyl) group or the carbon atoms of methyl groups at the ends of a branched (secondary or tertiary) alkyl group.

Exemplary groups of formula -(Ar¹)ₚ are phenyl; biphenyl; 3,5-diphenylbenzene; and 4,6-diphenyltriazine, each of which may be unsubstituted or substituted with one or more substituents as described above.

R³ is preferably a C₁₋₂₀ alkyl group, optionally a C₁₋₁₂ alkyl group, or a phenyl group that may be unsubstituted or substituted with one or more C₁₋₂₀ alkyl groups.

Preferred C₁₋₂₀ alkyl groups R³ are C₃₋₂₀ branched alkyl groups, optionally C₃₋₁₂ branched alkyl groups; and C₄₋₂₀ alkyl groups containing one or more tertiary carbon atoms, optionally C₄₋₁₂ branched alkyl groups.

R⁴ is a group of formula -(Ar²)_{q} wherein Ar² in each occurrence is independently an aryl or heteroaryl group and q is at least 1, optionally 1, 2 or 3.

Ar² may independently in each occurrence be selected from C₆₋₂₀ aryl, optionally phenyl, and C₃₋₂₀ heteroaryl, optionally a heteroaryl containing 3-20 C atoms and one or more heteroatoms selected from O, S and N.

In the case where q is greater than 1, the group -(Ar²)_{q} may form a linear or branched chain of Ar¹ groups.

q is preferably 1.

Optionally, substituents of Ar², where present, are selected from the group consisting of branched, linear or cyclic C₁₋₂₀ alkyl wherein one or more non-adjacent, non-terminal C atoms of the alkyl group may be replaced with O, S, C=O and -COO-, and wherein one or more H atoms of the C₁₋₂₀ alkyl may be replaced with F. Preferred substituents are selected from branched, linear or cyclic C₁₋₁₀ alkyl.

Exemplary groups of formula -(Ar²)_{q} are phenyl; biphenyl; 3,5-diphenylbenzene; and 4,6-diphenyltriazine, each of which may be unsubstituted or substituted with one or more substituents as described above.

R⁴ is preferably a phenyl group that may be unsubstituted or substituted with one or more C₁₋₂₀ alkyl groups.

Preferably, R⁴ is unsubstituted phenyl or phenyl having a C₁₋₂₀ alkyl group 4-substituent.

Preferred C₁₋₂₀ alkyl groups R⁴ are C₃₋₂₀ branched alkyl groups, optionally C₃₋₁₂ branched alkyl groups; and C₄₋₂₀ alkyl groups containing one or more tertiary carbon atoms, optionally C₄₋₁₂ branched alkyl groups.

w may be 0, 1, 2 or 3.

If present, R⁵ in each occurrence may be the same or different and may be selected from an unsubstituted or substituted C₆₋₂₀ aryl; an unsubstituted or substituted 5-20 membered heteroaryl; or a branched, linear or cyclic C₁₋₂₀ alkyl wherein one or more non-adjacent, non-terminal C atoms of the alkyl group may be replaced with O, S, C=O and -COO-, and wherein one or more H atoms of the C₁₋₂₀ alkyl may be replaced with F

Preferably, w is 0 and the compound of formula (I) has formula (Ia):

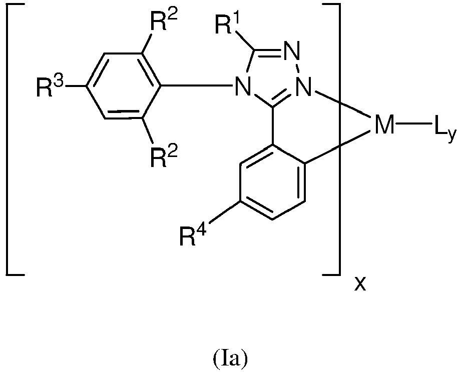

Exemplary compounds of formula (I) include the following:

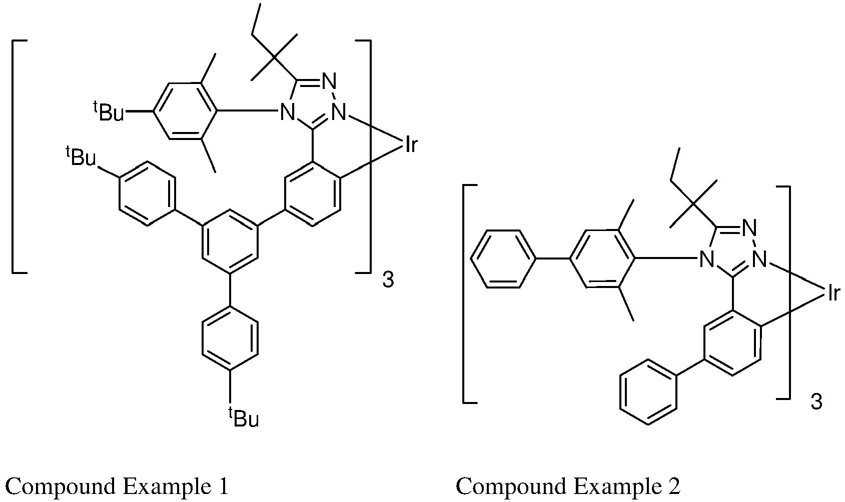

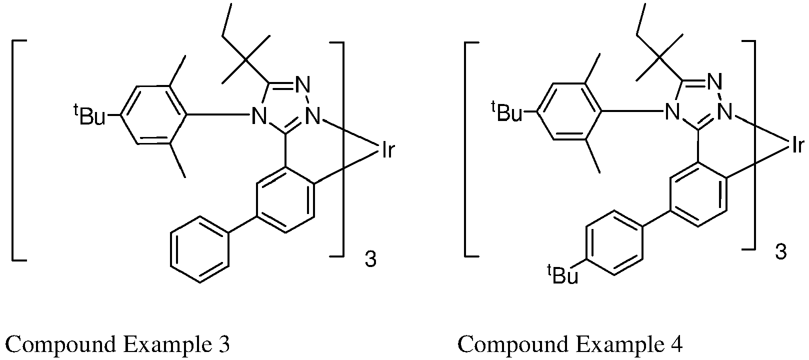

Compounds of formula (I) preferably have a photoluminescence spectrum with a peak in the range of 400-500 nm, optionally 420-490 nm, optionally 460-480 nm.

The photoluminescence spectrum of a compound of formula (I) may be measured by casting 5 wt % of the material in a PMMA film onto a quartz substrate to achieve transmittance values of 0.3-0.4 and measuring in a nitrogen environment using apparatus C9920-02 supplied by Hamamatsu.

### Host Material

The host material has a triplet excited state energy level T₁ that is no more than 0.1 eV lower than, and preferably at least the same as or higher than, the phosphorescent compound of formula (I) in order to allow transfer of triplet excitons from the host material to the phosphorescent compound of formula (I).

The triplet excited state energy levels of the host material and the phosphorescent compound may be determined from their respective phosphorescence spectra. The phosphorescence spectrum of a host material may be determined by the energy onset of the phosphorescence spectrum measured by low temperature phosphorescence spectroscopy (Y.V. Romaovskii et al, Physical Review Letters, 2000, 85 (5), p1027, A.van Dijken et al, Journal of the American Chemical Society, 2004, 126, p7718).

The host material may be a polymer or a non-polymeric compound.

An exemplary non-polymeric host material is an optionally substituted compound of formula (X): 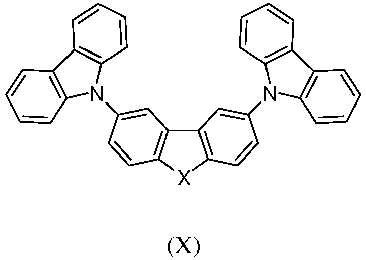 wherein X is O or S.

Each of the benzene rings of the compound of formula (X) may independently be unsubstituted or substituted with one or more substituents. Substituents may be selected from C₁₋₂₀ alkyl wherein one or more non-adjacent, non-terminal C atoms of the alkyl may be replaced with O, S, COO, C=O or SiR⁸ wherein the groups R⁸ are the same or different and are as described above, and one or more H atoms of the alkyl may be replaced with F.

The compound of formula (I) may be mixed with the host material or may be covalently bound to the host material. In the case where the host material is a polymer, the metal complex may be provided as a main chain repeat unit, a side group of a repeat unit, or an end group of the polymer.

In the case where the compound of formula (I) is provided as a side group, the metal complex may be directly bound to a main chain of the polymer or spaced apart from the main chain by a spacer group. Exemplary spacer groups include C₁₋₂₀ alkyl groups, aryl-C₁₋₂₀ alkyl groups and C₁₋₂₀ alkoxy groups. The polymer main chain or spacer group may be bound to phenyltriazole; or (if present) another ligand of the compound of formula (I).

If the compound of formula (I) is bound to a polymer comprising conjugated repeat units then it may be bound to the polymer such that there is no conjugation between the conjugated repeat units and the compound of formula (I), or such that the extent of conjugation between the conjugated repeat units and the compound of formula (I) is limited.

If the compound of formula (I) is mixed with a host material then the host: emitter weight ratio may be in the range of 50 - 99.5 : 50 - 0.5.

If the compound of formula (I) is bound to a polymer then repeat units or end groups containing a compound of formula (I) may form 0.5 - 20 mol percent, more preferably 1 - 10 mol percent of the polymer.

Exemplary host polymers include polymers having a non-conjugated backbone with charge-transporting groups pendant from the non-conjugated backbone, for example poly(9-vinylcarbazole), and polymers comprising conjugated repeat units in the backbone of the polymer. If the backbone of the polymer comprises conjugated repeat units then the extent of conjugation between repeat units in the polymer backbone may be limited in order to maintain a triplet energy level of the polymer that is no lower than that of the phosphorescent compound of formula (I).

Exemplary repeat units of a conjugated polymer include unsubstituted or substituted monocyclic and polycyclic heteroarylene repeat units; unsubstituted or substituted monocyclic and polycyclic arylene repeat units as disclosed in for example, Adv. Mater. 2000 12(23) 1737-1750 and include: 1,2-, 1,3- and 1,4-phenylene repeat units as disclosed in J. Appl. Phys. 1996, 79, 934; 2,7-fluorene repeat units as disclosed in EP 0842208; indenofluorene repeat units as disclosed in, for example, Macromolecules 2000, 33(6), 2016-2020; and spirofluorene repeat units as disclosed in, for example EP 0707020. Each of these repeat units is optionally substituted. Examples of substituents include solubilising groups such as C₁₋₂₀ alkyl or alkoxy; electron withdrawing groups such as fluorine, nitro or cyano; and substituents for increasing glass transition temperature (Tg) of the polymer.

One exemplary class of repeat units are unsubstituted or substituted repeat units of formula (IV): 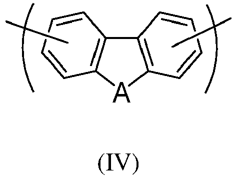 wherein A is O, S, NR¹¹, CR¹¹₂, or SiR¹¹₂; R¹¹ in each occurrence is the same or different and is H or a substituent, and wherein the two groups R¹¹ may be linked to form a ring.

Each R¹¹ is preferably a substituent, and each R¹¹ may independently be selected from the group consisting of:
C₁₋₂₀ alkyl, wherein one or more non-adjacent, non-terminal C atoms may be replaced with unsubstituted or substituted C₅₋₂₀ aryl or C₃₋₂₀ heteroaryl, optionally phenyl, O, S, substituted N, C=O or -COO-;
a group of formula -(Ar⁶)ᵣ wherein each Ar⁶ is independently an aryl or heteroaryl group, optionally a C₅₋₂₀ aryl or C₃₋₂₀ heteroaryl group, optionally phenyl; r is at least 1; optionally 1, 2 or 3; and -(Ar⁶)ᵣmay form a linear or branched chain of Ar⁶ groups in the case where r is at least 2; and
a crosslinkable-group, for example a group comprising a double bond such and a vinyl or acrylate group, or a benzocyclobutane group.

In the case where R¹¹ is -(Ar⁶)ᵣ, the or each group Ar⁶ may be unsubstituted or may be substituted with one or more substituents R¹⁰ selected from the group consisting of:
alkyl, optionally C₁₋₂₀ alkyl, wherein one or more non-adjacent, non-terminal C atoms may be replaced with O, S, substituted N, C=O and -COO- and one or more H atoms of the alkyl group may be replaced with F; and
fluorine, nitro and cyano.

Preferred groups R¹⁰ are selected from C₁₋₂₀ alkyl.

Aromatic carbon atoms of the repeat unit of formula (IV) may be unsubstituted or substituted with one or more substituents. Substituents may be selected from the group consisting of: alkyl, for example C₁₋₂₀ alkyl, wherein one or more non-adjacent, non-terminal C atoms may be replaced with O, S, substituted N, C=O and -COO-; C₅₋₂₀ aryl that may be unsubstituted or substituted with one or more substituents; C₃₋₂₀ heteroaryl that may be unsubstituted or substituted with one or more substituents; fluorine; and cyano. Particularly preferred substituents include C₁₋₂₀ alkyl and substituted or unsubstituted C₅₋₂₀ aryl, for example phenyl. Optional substituents for the aryl include one or more C₁₋₂₀ alkyl groups.

Where present, substituted N may independently in each occurrence be NR¹⁶ wherein R¹⁶ is alkyl, optionally C₁₋₂₀ alkyl, or optionally substituted aryl or heteroaryl, optionally phenyl. Optional substituents for aryl or heteroaryl R¹⁶ may be selected from R¹⁰.

Preferably, each R¹¹ is selected from the group consisting of C₁₋₂₀ alkyl and optionally substituted phenyl. Optional substituents for phenyl include one or more C₁₋₂₀ alkyl groups.

If the compound of formula (I) is provided as a side-chain of the polymer then A may be NR¹¹, CR¹¹₂, or SiR¹¹₂ and at least one R¹¹ may comprise a compound of formula (I) that is either bound directly to N, C or Si or spaced apart from A by a spacer group.

The extent of conjugation of repeat units of formulae (IV) may be limited by (a) selecting the linking positions of the repeat unit and / or (b) substituting one or more aromatic carbon atoms adjacent to linking positions of the repeat unit in order to create a twist with the adjacent repeat unit or units, for example a 2,7-linked fluorene carrying a C₁₋₂₀ alkyl substituent in one or both of the 3- and 6-positions.

Exemplary repeat units of formula (IV) include the following:

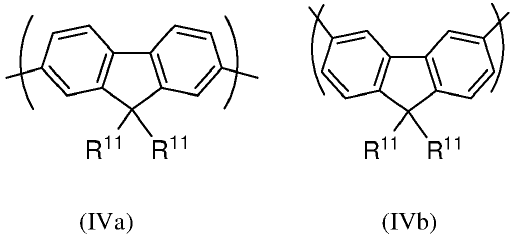

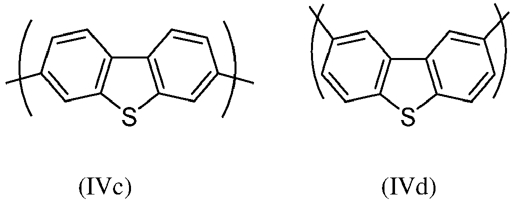

A host polymer may contain only one repeat unit of formula (IV) or two or more different repeat units of formula (IV).

Another exemplary class of repeat units is phenylene repeat units, such as phenylene repeat units of formula (V): 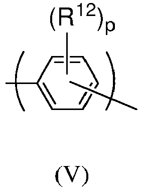 wherein p is 0, 1, 2, 3 or 4, optionally 1 or 2, and R¹² independently in each occurrence is a substituent, optionally a substituent R¹¹ as described above, for example C₁₋₂₀ alkyl, phenyl that is unsubstituted or substituted with one or more C₁₋₂₀ alkyl groups or a crosslinkable group.

The repeat unit of formula (V) may be 1,4- linked, 1,2-linked or 1,3-linked.

If the repeat unit of formula (V) is 1,4-linked and if p is 0 then the extent of conjugation of repeat unit of formula (V) to one or both adjacent repeat units may be relatively high.

If p is at least 1, and / or the repeat unit is 1,2- or 1,3 linked, then the extent of conjugation of repeat unit of formula (V) to one or both adjacent repeat units may be relatively low. In one preferred arrangement, the repeat unit of formula (V) is 1,3-linked and p is 0, 1, 2 or 3. In another preferred arrangement, the repeat unit of formula (V) has formula (Va):

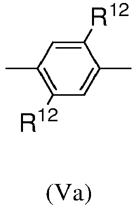

Arylene repeat units such as repeat units of formula (IV) and (V) may be fully conjugated with aromatic or heteroaromatic group of adjacent repeat units. Additionally or alternatively, a host polymer may contain a conjugation-breaking repeat unit that completely breaks conjugation between repeat units adjacent to the conjugation-breaking repeat unit. An exemplary conjugation-breaking repeat unit has formula (VI):

-(Ar⁷-Sp¹-Ar⁷)- (VI)

wherein Ar⁷ independently in each occurrence represents an aromatic or heteroaromatic group that may be unsubstituted or substituted with one or more substituents, and Sp¹ represents a spacer group comprising at least one sp³ hybridised carbon atom separating the two groups Ar⁷. Preferably, each Ar⁷ is phenyl and Sp¹ is a C₁₋₁₀ alkyl group. Substituents of Ar⁷ may be selected from groups R¹¹ described above with reference to formula (IV), and are preferably selected from C₁₋₂₀ alkyl.

A host polymer may comprise charge-transporting units CT that may be hole-transporting units or electron transporting units.

A hole transporting unit may have a low electron affinity (2 eV or lower) and low ionisation potential (5.8 eV or lower, preferably 5.7 eV or lower, more preferred 5.6 eV or lower).

An electron-transporting unit may have a high electron affinity (1.8 eV or higher, preferably 2 eV or higher, even more preferred 2.2 eV or higher) and high ionisation potential (5.8 eV or higher) Suitable electron transport groups include groups disclosed in, for example, Shirota and Kageyama, Chem. Rev. 2007, 107, 953-1010.

Electron affinities and ionisation potentials may be measured by cyclic voltammetry (CV). The working electrode potential may be ramped linearly versus time.

When cyclic voltammetry reaches a set potential the working electrode's potential ramp is inverted. This inversion can happen multiple times during a single experiment. The current at the working electrode is plotted versus the applied voltage to give the cyclic voltammogram trace.

Apparatus to measure HOMO or LUMO energy levels by CV may comprise a cell containing a tert-butyl ammonium perchlorate/ or tertbutyl ammonium hexafluorophosphate solution in acetonitrile, a glassy carbon working electrode where the sample is coated as a film, a platinium counter electrode (donor or acceptor of electrons) and a reference glass electrode no leak Ag/AgCl. Ferrocene is added in the cell at the end of the experiment for calculation purposes. (Measurement of the difference of potential between Ag/AgCl/ferrocene and sample/ferrocene).

Method and settings:
3mm diameter glassy carbon working electrode
Ag/AgCl/no leak reference electrode
Pt wire auxiliary electrode
0.1 M tetrabutylammonium hexafluorophosphate in acetonitrile
LUMO = 4.8 - ferrocene (peak to peak maximum average) + onset

### Sample: 1 drop of 5mg/mL in toluene spun @3000rpm LUMO (reduction) measurement:

A good reversible reduction event is typically observed for thick films measured at 200 mV/s and a switching potential of -2.5V. The reduction events should be measured and compared over 10 cycles, usually measurements are taken on the 3^{rd} cycle. The onset is taken at the intersection of lines of best fit at the steepest part of the reduction event and the baseline.

Exemplary hole-transporting repeat units have formula (IX): 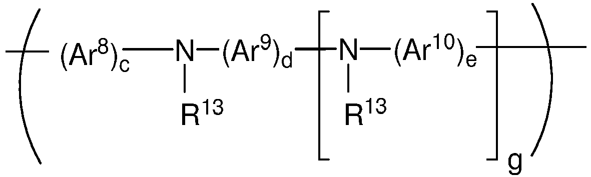 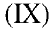 wherein Ar⁸, Ar⁹ and Ar¹⁰ in each occurrence are independently selected from substituted or unsubstituted aryl or heteroaryl, g is 0, 1 or 2, preferably 0 or 1, R¹³ independently in each occurrence is H or a substituent, preferably a substituent, and c, d and e are each independently 1, 2 or 3.

R¹³, which may be the same or different in each occurrence when g is 1 or 2, is preferably selected from the group consisting of alkyl, for example C₁₋₂₀ alkyl, Ar¹¹ and a branched or linear chain of Ar¹¹ groups wherein Ar¹¹ in each occurrence is independently substituted or unsubstituted aryl or heteroaryl.

Any two aromatic or heteroaromatic groups selected from Ar⁸, Ar⁹, and, if present, Ar¹⁰ and Ar¹¹ that are directly bound to the same N atom may be linked by a direct bond or a divalent linking atom or group. Preferred divalent linking atoms and groups include O, S; substituted N; and substituted C.

Ar⁸ and Ar¹⁰ are preferably C₆₋₂₀ aryl, more preferably phenyl, that may be unsubstituted or substituted with one or more substituents.

In the case where g = 0, Ar⁹ is preferably C₆₋₂₀ aryl, more preferably phenyl, that may be unsubstituted or substituted with one or more substituents.

In the case where g = 1, Ar⁹ is preferably C₆₋₂₀ aryl, more preferably phenyl or a polycyclic aromatic group, for example naphthalene, perylene, anthracene or fluorene, that may be unsubstituted or substituted with one or more substituents.

R¹³ is preferably Ar¹¹ or a branched or linear chain of Ar¹¹ groups. Ar¹¹ in each occurrence is preferably phenyl that may be unsubstituted or substituted with one or more substituents.

Exemplary groups R¹³ include the following, each of which may be unsubstituted or substituted with one or more substituents, and wherein * represents a point of attachment to N:

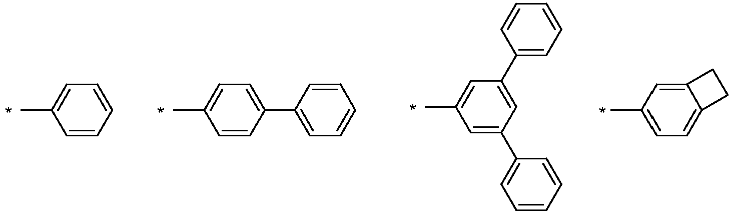

c, d and e are preferably each 1.

Ar⁸, Ar⁹, and, if present, Ar¹⁰ and Ar¹¹ are each independently unsubstituted or substituted with one or more, optionally 1, 2, 3 or 4, substituents. Optionally, substituents are selected from substituted or unsubstituted alkyl, optionally C₁₋₂₀ alkyl, wherein one or more non-adjacent, non-termial C atoms may be replaced with optionally substituted aryl or heteroaryl (preferably phenyl), O, S, C=O or -COO- and one or more H atoms may be replaced with F.

Preferred substituents of Ar⁸, Ar⁹, and, if present, Ar¹⁰ and Ar¹¹ are C₁₋₄₀ hydrocarbyl, preferably C₁₋₂₀ alkyl.

Preferred repeat units of formula (IX) include unsubstituted or substituted units of formulae (IX-1), (IX-2) and (IX-3):

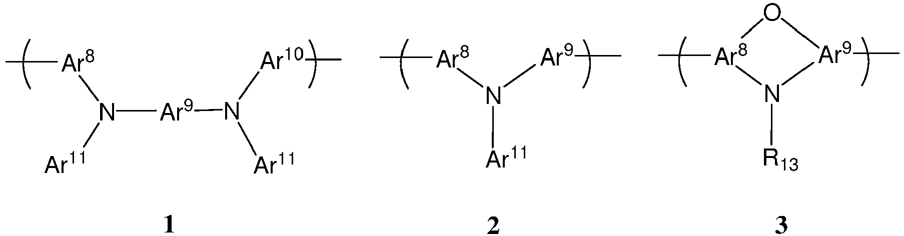

Triazines form an exemplary class of electron-transporting units, for example optionally substituted di-or tri-(hetero)aryltriazine attached as a side group through one of the (hetero)aryl groups. Other exemplary electron-transporting units are pyrimidines and pyridines; sulfoxides and phosphine oxides; benzophenones; and boranes, each of which may be unsubstituted or substituted with one or more substituents, for example one or more C₁₋₂₀ alkyl groups.

Exemplary electron-transporting units CT have formula (VII): 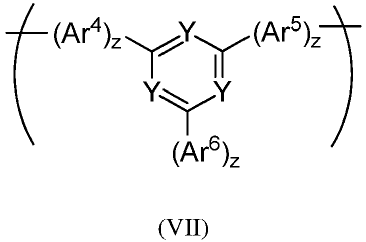 wherein Ar⁴, Ar⁵ and Ar⁶ are in each occurrence are independently selected from substituted or unsubstituted aryl or heteroaryl; z in each occurrence is independently at least 1, optionally 1, 2 or 3; and Y is N or CR⁷, wherein R⁷ is H or a substituent, preferably H or C₁₋₁₀ alkyl... Where present, substituents of Ar⁴, Ar⁵ and Ar⁶ are each independently selected from substituted or unsubstituted alkyl, optionally C₁₋₂₀ alkyl, wherein one or more non-adjacent, non-terminal C atoms may be replaced with optionally substituted aryl or heteroaryl (preferably phenyl), O, S, C=O or -COO- and one or more H atoms may be replaced with F. Preferably, Ar⁴, Ar⁵ and Ar⁶ of formula (VII) are each phenyl, each phenyl being optionally and independently substituted with one or more C₁₋₂₀ alkyl groups.

In one preferred embodiment, all 3 groups Y are N.

If all 3 groups Y are CR⁷ then at least one of Ar⁴, Ar⁵ and Ar⁶ is preferably a heteroaromatic group comprising N.

In one arrangement, Ar⁴, Ar⁵ and Ar⁶ are phenyl in each occurrence.

Ar⁶ of formula (VII) is preferably phenyl, and is optionally substituted with one or more C₁₋₂₀ alkyl groups or a crosslinkable unit.

The charge-transporting units CT may be provided as distinct repeat units formed by polymerising a corresponding monomer. Alternatively, the one or more CT units may form part of a larger repeat unit, for example a repeat unit of formula (VIII):

(̵(Ar³)_{q}-Sp-CT-Sp-(Ar³)_{q})̵ (VIII)

wherein CT represents a conjugated charge-transporting group; each Ar³ independently represents an unsubstituted or substituted aryl or heteroaryl; q is at least 1; and each Sp independently represents a spacer group forming a break in conjugation between Ar³ and CT.

Sp is preferably a branched, linear or cyclic C₁₋₂₀ alkyl group.

Exemplary CT groups include units of formula (IX) or (VII) described above.

Ar³ is preferably an unsubstituted or substituted aryl, optionally an unsubstituted or substituted phenyl or fluorene. Optional substituents for Ar³ may be selected from R⁸ as described above, and are preferably selected from one or more C₁₋₂₀ alkyl substituents.

q is preferably 1.

### White OLED

An OLED of the invention may be a white OLED containing a blue light-emitting compound of formula (I) and one or more further light-emitting materials having a colour of emission such that light emitted from the device is white. Further light-emitting materials include red and green light-emitting materials that may be fluorescent or phosphorescent. Optionally, all light emitted from a white OLED is phosphorescence.

The one or more further light-emitting materials may present in the same light-emitting layer as the compound of formula (I) or may be provided in one or more further light-emitting layers of the device. In one optional arrangement an OLED may comprise a red light-emitting layer and a green and blue light-emitting layer. Optionally, the red layer is a hole-transporting layer that is adjacent to the green and blue light-emitting layer.

The light emitted from a white OLED may have CIE x coordinate equivalent to that emitted by a black body at a temperature in the range of 2500-9000K and a CIE y coordinate within 0.05 or 0.025 of the CIE y co-ordinate of said light emitted by a black body, optionally a CIE x coordinate equivalent to that emitted by a black body at a temperature in the range of 2700-600K.

A green emitting material may have a photoluminescent spectrum with a peak in the range of more than 500 nm up to 580 nm, optionally more than 490 nm up to 540 nm

A red emitting material may optionally have a peak in its photoluminescent spectrum of more than 580 nm up to 630 nm, optionally 585 nm up to 625 nm.

### Polymer synthesis

Preferred methods for preparation of conjugated polymers, such as polymers comprising one or more of repeat units of formulae (IV), (V), (VI), (VII), (VIII) and (IX) as described above, comprise a "metal insertion" wherein the metal atom of a metal complex catalyst is inserted between an aryl or heteroaryl group and a leaving group of a monomer. Exemplary metal insertion methods are Suzuki polymerisation as described in, for example, WO 00/53656 and Yamamoto polymerisation as described in, for example, T. Yamamoto, "Electrically Conducting And Thermally Stable pi-Conjugated Poly(arylene)s Prepared by Organometallic Processes", Progress in Polymer Science 1993, 17, 1153-1205. In the case of Yamamoto polymerisation, a nickel complex catalyst is used; in the case of Suzuki polymerisation, a palladium complex catalyst is used.

For example, in the synthesis of a linear polymer by Yamamoto polymerisation, a monomer having two reactive halogen groups is used. Similarly, according to the method of Suzuki polymerisation, at least one reactive group is a boron derivative group such as a boronic acid or boronic ester and the other reactive group is a halogen. Preferred halogens are chlorine, bromine and iodine, most preferably bromine.

It will therefore be appreciated that repeat units illustrated throughout this application may be derived from a monomer carrying suitable leaving groups. Likewise, an end group or side group may be bound to the polymer by reaction of a suitable leaving group.

Suzuki polymerisation may be used to prepare regioregular, block and random copolymers. In particular, homopolymers or random copolymers may be prepared when one reactive group is a halogen and the other reactive group is a boron derivative group. Alternatively, block or regioregular copolymers may be prepared when both reactive groups of a first monomer are boron and both reactive groups of a second monomer are halogen.

As alternatives to halides, other leaving groups capable of participating in metal insertion include sulfonic acids and sulfonic acid esters such as tosylate, mesylate and triflate.

### Charge transporting and charge blocking layers

A hole transporting layer may be provided between the anode and the light-emitting layer or layers. Likewise, an electron transporting layer may be provided between the cathode and the light-emitting layer or layers.

Similarly, an electron blocking layer may be provided between the anode and the light-emitting layer and a hole blocking layer may be provided between the cathode and the light-emitting layer. Transporting and blocking layers may be used in combination. Depending on its HOMO and LUMO levels, a single layer may both transport one of holes and electrons and block the other of holes and electrons.

A charge-transporting layer or charge-blocking layer may be crosslinked, particularly if a layer overlying that charge-transporting or charge-blocking layer is deposited from a solution. The crosslinkable group used for this crosslinking may be a crosslinkable group comprising a reactive double bond such and a vinyl or acrylate group, or a benzocyclobutane group. The crosslinkable group may be provided as a substituent pendant from the backbone of a charge-transporting or charge-blocking polymer. Following formation of a charge-transporting or charge blocking layer, the crosslinkable group may be crosslinked by thermal treatment or irradiation.

If present, a hole transporting layer located between the anode and the light-emitting layers preferably has a HOMO level of less than or equal to 5.5 eV, more preferably around 4.8-5.5 eV as measured by cyclic voltammetry. The HOMO level of the hole transport layer may be selected so as to be within 0.2 eV, optionally within 0.1 eV, of an adjacent layer (such as a light-emitting layer) in order to provide a small barrier to hole transport between these layers.

If present, an electron transporting layer located between the light-emitting layers and cathode preferably has a LUMO level of around 2.5-3.5 eV as measured by square wave cyclic voltammetry. A layer of a silicon monoxide or silicon dioxide or other thin dielectric layer having thickness in the range of 0.2-2 nm may be provided between the light-emitting layer nearest the cathode and the cathode. HOMO and LUMO levels may be measured using cyclic voltammetry.

If present, a hole-blocking layer may comprise or consist of a compound of formula (XII): 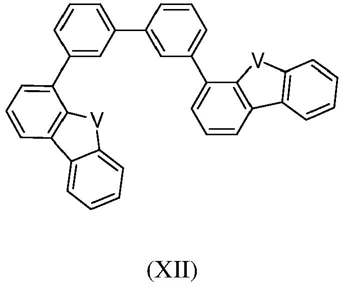 wherein V in each occurrence is independently S or O, preferably S. The compound of formula (XII) may be unsubstituted or may be substituted with one or more substituents, optionally one or more C₁₋₄₀ hydrocarbyl groups, optionally one or more C₁₋₂₀ alkyl groups.

A hole transporting layer may contain a hole-transporting (hetero)arylamine, such as a homopolymer or copolymer comprising hole transporting repeat units of formula (IX). Exemplary copolymers comprise repeat units of formula (IX) and optionally substituted (hetero)arylene co-repeat units, such as phenyl, fluorene or indenofluorene repeat units as described above, wherein each of said (hetero)arylene repeat units may optionally be substituted with one or more substituents such as alkyl or alkoxy groups. Specific co-repeat units include fluorene repeat units of formula (IVa) and phenylene repeat units of formula (V) as described above. A hole-transporting copolymer containing repeat units of formula (IX) may contain 25-95 mol % of repeat units of formula (IX).

An electron transporting layer may contain a polymer comprising a chain of optionally substituted arylene repeat units, such as a chain of fluorene repeat units.

More than one hole-transporting layer or more than one electron-transporting layer may be provided. In an embodiment, two or more hole-transporting layers are provided.

### Hole injection layers

A conductive hole injection layer, which may be formed from a conductive organic or inorganic material, may be provided between the anode and the light-emitting layer or layers to assist hole injection from the anode into the layer or layers of semiconducting polymer. A hole transporting layer may be used in combination with a hole injection layer.

Examples of doped organic hole injection materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and optionally substituted polythiophene or poly(thienothiophene). Examples of conductive inorganic materials include transition metal oxides such as VOx, MoOx and RuOx as disclosed in Journal of Physics D: Applied Physics (1996), 29(11), 2750-2753.

### Cathode

The cathode is selected from materials that have a workfunction allowing injection of electrons into the light-emitting layer or layers. Other factors influence the selection of the cathode such as the possibility of adverse interactions between the cathode and the light-emitting materials. The cathode may consist of a single material such as a layer of aluminium. Alternatively, it may comprise a plurality of metals, for example a bilayer of a low workfunction material and a high workfunction material such as calcium and aluminium as disclosed in WO 98/10621. The cathode may contain a layer containing elemental barium, for example as disclosed in WO 98/57381, Appl. Phys. Lett. 2002, 81(4), 634 and WO 02/84759. The cathode may contain a thin (e.g. 1-5 nm thick) layer of metal compound between the light-emitting layer(s) of the OLED and one or more conductive layers of the cathode, such as one or more metal layers. Exemplary metal compounds include an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

Organic optoelectronic devices tend to be sensitive to moisture and oxygen. Accordingly, the substrate 1 preferably has good barrier properties for prevention of ingress of moisture and oxygen into the device. The substrate is commonly glass, however alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850.

The device may be encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric as disclosed in, for example, WO 01/81649 or an airtight container as disclosed in, for example, WO 01/19142. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Solution processing

Suitable solvents for forming solution processable formulations of the light-emitting metal complex of formula (I) and compositions thereof may be selected from common organic solvents, such as mono- or poly-alkylbenzenes such as toluene and xylene and mono- or poly-alkoxybenzenes, and mixtures thereof. The formulation may comprise one or more solvents.

The formulation may comprise the compound of formula (I) dissolved in the solvent or solvents and, optionally, one or more further materials dissolved or dispersed, preferably dissolved, in the solvent or solvents.

The one or more further materials may comprise or consist of one or more of a host material and one or more further light-emitting materials.

Exemplary solution deposition techniques for forming a light-emitting layer containing a compound of formula (I) include printing and coating techniques such spin-coating, dip-coating, roll-to-roll coating or roll-to-roll printing, doctor blade coating, slot die coating, gravure printing, screen printing and inkjet printing.

Coating methods, such as those described above, are particularly suitable for devices wherein patterning of the light-emitting layer or layers is unnecessary - for example for lighting applications or simple monochrome segmented displays.

Printing is particularly suitable for high information content displays, in particular full colour displays. A device may be inkjet printed by providing a patterned layer over the first electrode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the photoresist may be patterned to form channels which, unlike wells, extend over a plurality of pixels and which may be closed or open at the channel ends.

The same coating and printing methods may be used to form other layers of an OLED including (where present) a hole injection layer, a charge transporting layer and a charge blocking layer.

### Examples

### Compound Example 3

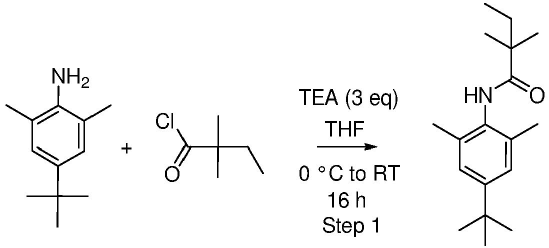

### Step 1:

A 5L 3-necked round-bottomed flask, equipped with a mechanical overhead stirrer, nitrogen inlet and exhaust. 2,6-dimethyl-4-*tert*-butyl aniline (200 g, 1.129 mol) and triethylamine (472 mL, 3.38 mol) were taken in THF (2 L) and cooled to 0 °C using an ice bath. 2,2-dimethylbutyroyl chloride (228 g, 1.69 mol) was slowly added at 0 °C. The mixture was allowed to warm to room temperature and stirred for 16 h. After completion of the reaction, it was filtered and washed with THF (1 L). The filtrate was concentrated to get crude product (255 g). The crude residue (255 g) was triturated with ethyl acetate (500 mL) and filtered to get 205 g of product with 99 % HPLC purity.
¹H-NMR (400 MHz, CDCl₃): δ [ppm] 1.01 (t, *J* = 7.6 Hz, 3H), 1.31 (s, 6H), 1.33 (s, 9H), 1.70 (q, *J* = 7.6 Hz, 2H), 2.23 (s, 6H), 6.84 (br, s, 1H), 7.09 (br, s, 1H).

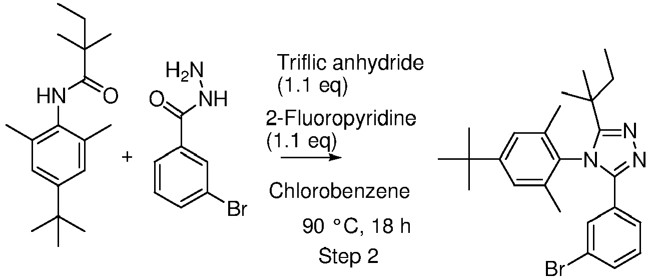

### Step 2:

A 5 L 3-necked round-bottomed flask, equipped with a mechanical overhead stirrer, reflux condenser, nitrogen inlet and exhaust. A mixture of the product of step 1 (115 g, 0.417 mol), 2-fluoro pyridine (44.59 g, 0.459 mol) and triflic anhydride (129.5 g, 0.459 mol) was taken in chlorobenzene (1150 mL). Benzoic hydrazide (98.7 g, 0.459 mol) was added at room temperature. The reaction mixture was stirred at RT for an hour then heated to 90 °C for 18 h. Crude LCMS analysis showed complete conversion of starting material. The reaction mixture was diluted with chloroform and washed with 10 % sodium bicarbonate solution (1 L). The organic layer washed with water (1L x 2), dried over sodium sulphate and concentrated (168 g). The crude product (168 g) was purified by silica column chromatography using hexane/ ethyl acetate (-50 %) to get 120 g of product with 96 % HPLC purity. The solid thus obtained was taken in hot acetonitrile (1.5 L) and slowly cooled to room temperature. The solid obtained was filtered to get 100 g of product with 99.57 % HPLC purity.
¹H-NMR (400 MHz, DMSO-d₆): δ [ppm] 0.79 (t, *J* = 7.2 Hz, 3H), 1.12 (s, 6H), 1.31 (s, 9H), 1.62 (q, *J* = 7.2 Hz, 2H), 1.91 (s, 6H), 7.16 (s, 1H), 7.27 - 7.39 (m, 3H), 7.56 (d, *J* = 7.6 Hz 1H).

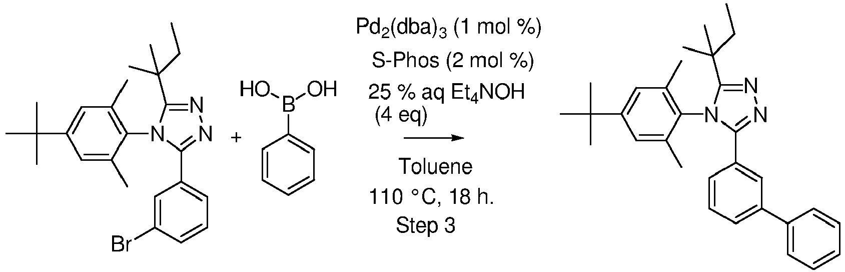

### Step 3:

A 2 L 3-necked round-bottomed flask, equipped with a mechanical overhead stirrer, reflux condenser, nitrogen inlet and exhaust. To a mixture of the product from step 2 (50 g, 0.1100 mol) and phenyl boronic acid (14.75 g, 0.1210 mol) in toluene (500 mL) nitrogen gas purged for an hour. Pd₂(dba)₃ (1 g, 0.0011 mol) and S-Phos (0.9 g, 0.0022 mol) were added. To this mixture, degased aqueous 25 % tetraethylammonium hydroxide solution (260 mL, 0.440 mol) was added at 60 °C. The mixture was heated at 110 °C for 18 h. After complete conversion by TLC, the mixture was filtered through celite bed and washed with ethyl acetate (1 L). The combined organic phase washed with water (500 mL), dried over sodium sulphate and concentrated. The crude residue (50 g) thus obtained was purified by silica gel column using 40 % of ethyl acetate in hexane to get 38 g of product with 98 % HPLC purity. It was taken in hot acetonitrile and slowly cooled to room temperature the solid obtained were filtered to get 28 g of product with 99.01 % HPLC purity. Hot acetonitrile crystallization was repeated again to get 21 g of 99.85 % HPLC purity. The material was dissolved in dichloromethane (200 mL), filtered at hot and concentrated to obtain 20.5 g of product with 99.85 % HPLC purity.
¹H-NMR (400 MHz, CDCl₃): δ [ppm] 0.79 (t, *J* = 7.6 Hz, 3H), 1.23 (s, 6H), 1.37 (s, 9H), 1.73 (q, *J* = 7.6 Hz, 2H), 2.01 (s, 6H), 7.20 (s, 2H), 7.21 - 7.24 (m, 2H), 7.28 - 7.40 (m, 5H), 7.53 (d, *J* = 7.6 Hz, 1H), 7.70 (d, *J* = 7.6 Hz, 1H).

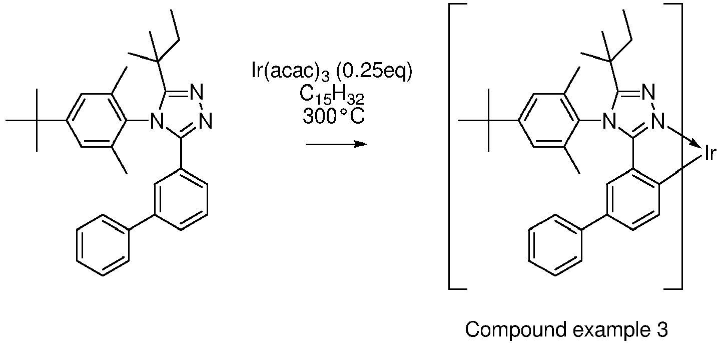

### Step 4:

A 50 mL 2-necked round-bottomed flask, equipped with a Young's tap, magnetic stirrer bar, reflux condenser, nitrogen inlet and exhaust. The product of step 3 (5 g, 0.011 mol) and Ir(acac)₃ (1.35 g, 0.0028 mol) were placed in the 2-necked flask and the flask evacuated and back filled with N₂ three times. Pentadecane (2 mL) that had been degassed with N₂ for 15 minutes was added to the flask. The flask was placed in a sand bath and heated at 300 °C for 24h before being allowed to cool to room temperature. The resultant black solid was dissolved in toluene (20 mL), transferred to a single necked round bottomed flask and concentrated *in vacuo.* Purification by column chromatography (gradient elution, 0-20% ethyl acetate in dichloromethane) gave 4.03 g of compound example 3. Compound example 3 was dissolved in the minimum amount of dichloromethane and precipitated with excess acetonitrile to give 3.54 g of compound example 3 with 99.48% HPLC purity.
¹H-NMR (600 MHz, THF-d₈): δ [ppm] 0.93 (t, *J* = 7.4 Hz, 9H), 1.11 (s, 9H), 1.22 (s, 9H), 1.42 (s, 27H), 1.55 - 1.63 (m, 3H), 1.65 - 1.71 (m, 3H), 2.03 (s, 9H), 2.18 (s, 9H), 6.31 (d, *J* = 1.8 Hz, 3H), 6.96 (br d, *J* = 7.9 Hz, 3H), 7.01 - 7.04 (m, 3H), 7.09 - 7.12 (m, 6H), 7.12 - 7.15 (m, 6H), 7.17 (br s, 3H), 7.38 (d, *J* = 2.1 Hz, 3H), 7.40 (d, *J* = 2.0 Hz, 3H).

### Compound Examples 1, 2 and 4

Compound Examples 1, 2 and 4 were made by a method analogous to the route above.

Analytical specifications for Compound Example 1 (99.77% HPLC purity):
¹H-NMR (600 MHz, THF-d₈): δ [ppm] 0.85 - 1.02 (m, 9H), 0.89 (s, 27H), 1.08 (s, 9H), 1.12 (br t, 1H), 1.22 (s, 9H), 1.38 (s, 54H), 1.54 - 1.63 (m, 3H), 1.65 - 1.71 (m, 3H), 2.15 (s, 9H), 2.21 (s, 9H), 2.30 (s, 2H), 6.45 (d, *J* = 1.9 Hz, 3H), 7.08 - 7.11 (m, 3H), 7.15 (s, 3H), 7.16-7.18 (m, 3H), 7.37-7.40 (m, 3H), 7.42 (d, *J* = 1.6 Hz, 6H), 7.50 (d, *J* = 8.5 Hz, 12H), 7.59 - 7.62 (m, 12H), 7.60 - 7.61 (m, 3H).

Analytical specifications for Compound Example 2 (99.71% HPLC purity):
¹H-NMR (600 MHz, THF-d₈): δ [ppm] 1.00 (t, *J* = 7.4 Hz, 9H), 1.22 (s, 9H), 1.30 (s, 9H), 1.64 - 1.70 (m, 3H), 1.75 - 1.79 (m, 3H), 2.13 (s, 9H), 2.27 (s, 9H), 6.33 (d, *J* = 2.0 Hz, 3H), 6.93 - 6.97 (m, 3H), 6.98 - 7.02 (m, 9H), 7.09 - 7.13 (m, 6H), 7.25 (d, *J* = 8.0 Hz, 3H), 7.39 - 7.43 (m, 3H), 7.50 (t, *J* = 7.7 Hz, 6H), 7.65 (s, 6H), 7.75 - 7.78 (m, 6H).

Analytical specifications for Compound Example 4 (99.92% HPLC purity):
¹H-NMR (600 MHz, THF-d₈): δ [ppm] 0.92 (t, *J* = 7.0 Hz, 9H), 1.11 (s, 9H), 1.21 (s, 9H), 1.26 (s, 27H), 1.42 (s, 27H), 1.56 - 1.63 (m, 3H), 1.64 - 1.71 (m, 3H), 2.02 (s, 9H), 2.18 (s, 6H), 6.24 (d, *J* = 1.9 Hz, 3H), 6.92 (dd, *J* = 7.9, 2.0 Hz, 3H), 7.04 (d, *J* = 8.5 Hz, 6H), 7.15 (d, *J* = 8.0 Hz, 3H), 7.19 (d, *J* = 8.5 Hz, 6H), 7.38 (s, 3H), 7.39 (s, 3H).

### Device Example 1

A white organic light-emitting device having the following structure was prepared:
ITO / HIL / LEL (R) / LEL (G, B) / HBL / ETL / Cathode
wherein ITO is an indium-tin oxide anode; HIL is a hole-injecting layer comprising a hole-injecting material, LEL (R) is a red light-emitting hole-transporting layer, LEL (G, B) is a green and blue light-emitting layer, HBL is a hole-blocking layer; and ETL is an electron-transporting layer.

A substrate carrying ITO (45 nm) was cleaned using UV / Ozone. A hole injection layer was formed to a thickness of about 35 nm by spin-coating a formulation of a hole-injection material available from Nissan Chemical Industries. A red light-emitting layer was formed to a thickness of about 20 nm by spin-coating a crosslinkable red-emitting hole-transporting polymer, and crosslinking the polymer by heating at 180°C. The green and blue light-emitting layer was formed to a thickness of about 70 nm by spin-coating Host 1 (74 wt %), a green phosphorescent emitter (1 wt %) and Compound Example 1 (24 wt %) wherein the green phosphorescent emitter is a tris(phenylpyridine)iridium emitter wherein each phenylpyridine ligand is substituted with an alkylated 3,5-diphenylbenzene dendron. A hole-blocking layer of Hole Blocking Compound 1 was evaporated onto the light-emitting layer to a thickness of 10 nm. An electron-transporting layer was formed by spin-coating a polymer comprising Electron-Transporting Unit 1 to a thickness of 10 nm. A cathode was formed on the electron-transporting layer of a first layer of sodium fluoride of about 3.5 nm thickness, a layer of aluminium of about 100 nm thickness and a layer of silver of about 100 nm thickness.

Host 1 has formula:

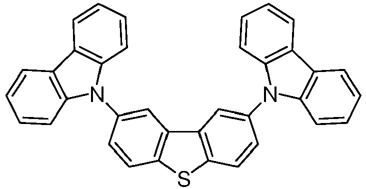

The red-emitting hole transporting polymer was formed by Suzuki polymerisation as described in WO 00/53656 to give a polymer comprising crosslinkable phenylene repeat units of formula (Va); amine repeat units of formula (IX-1) and a 3 mol % of a red phosphorescent group of formula:

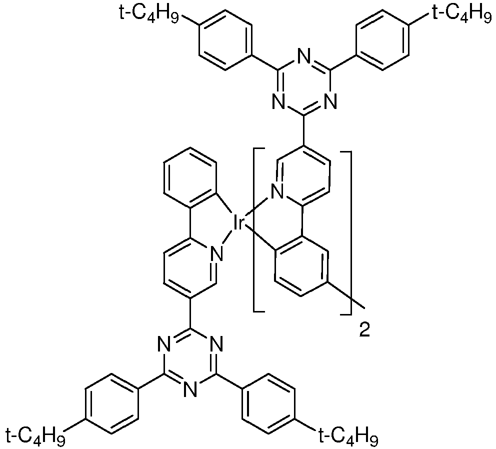

Electron-Transporting Unit 1 has formula:

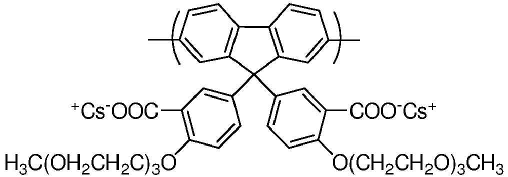

Hole Blocking Compound 1 has formula:

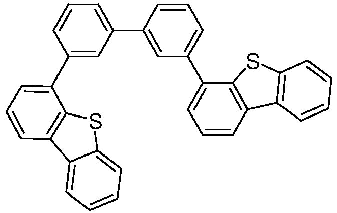

### Device Examples 2-4

Device Examples 2-4 were prepared as described for Device Example 1 except that Compound Example 1 was replaced with Compound Examples 2-4 respectively.

### Comparative Devices 1-4

Comparative Devices were prepared as described for Device Examples 1-4 except that Comparative Compounds 1-4 were used in place of Compound Examples 1-4 respectively.

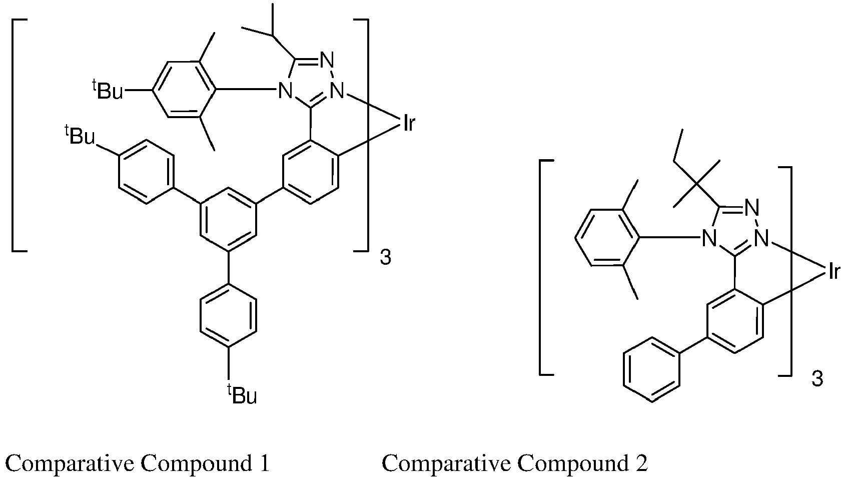

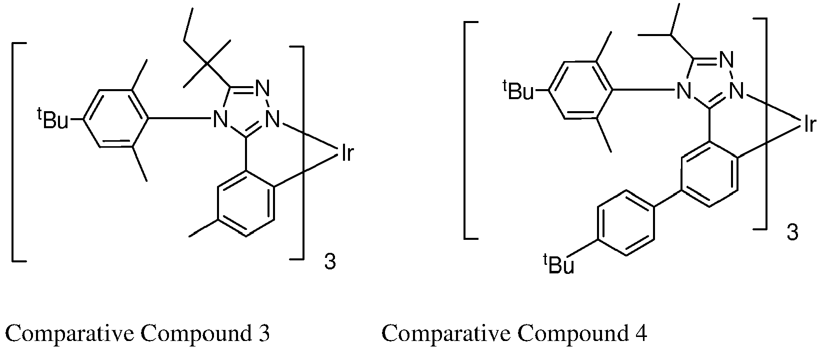

The time taken for brightness of the devices to fall to 70% of an initial brightness at constant current (T70) was measured. Results are set out in Table 1.

| **Device** | **R¹** | **R³** | **R⁴** | **T70 (normalised)** |
|---|---|---|---|---|
| Device Example 1 | neopentyl | t-butyl | DBPB | 1.00 |
| Comparative Device 1 | isopropyl | t-butyl | DBPB | 0.63 |
| Device Example 2 | neopentyl | phenyl | phenyl | 1.32 |
| Comparative Device 2 | neopentyl | H | phenyl | 1.04 |
| Device Example 3 | neopentyl | t-butyl | phenyl | 1.41 |
| Comparative Device 3 | neopentyl | t-butyl | methyl | 1.04 |
| Device Example 4 | neopentyl | t-butyl | t-butylphenyl | 1.63 |
| Comparative Device 4 | isopropyl | t-butyl | t-butylphenyl | 0.63 |

| | | | | |
|---|---|---|---|---|
| DBPB = 3,5-di(4-tert-butylphenyl)benzene | | | | |

## Claims

1. A phosphorescent compound of formula (I): 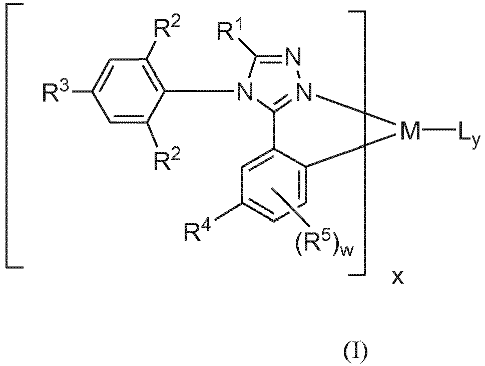 wherein:
M is a transition metal;
L in each occurrence is independently a mono- or poly-dentate ligand;
R¹ is a C₄₋₂₀ alkyl comprising at least one tertiary carbon atom;
R² independently in each occurrence is a linear, branched or cyclic C₁₋₂₀ alkyl group;
R³ is a linear, branched or cyclic C₁₋₂₀ alkyl group or a group of formula -(Ar¹)ₚ
wherein Ar¹ in each occurrence is independently an unsubstituted or substituted aryl or heteroaryl group and p is at least 1;
R⁴ is a group of formula -(Ar²)_{q} wherein Ar² in each occurrence is independently an unsubstituted or substituted aryl or heteroaryl group and q is at least 1;
R⁵ is a substituent;
w is 0 or a positive integer;
x is at least 1; and
y is 0 or a positive integer.

2. A compound according to claim 1 wherein M is selected from iridium, platinum, osmium, palladium, rhodium and ruthenium.

3. A compound according to claim 1 or 2 wherein y is 0.

4. A compound according to claim 3 wherein x is 3.

5. A compound according to any one of the preceding claims wherein a tertiary carbon atom of R¹ is directly bound to the triazole ring of formula (I).

6. A compound according to any one of the preceding claims wherein w is 0.

7. A compound according to any one of the preceding claims wherein Ar¹ in each occurrence is independently phenyl that is unsubstituted or substituted with one or more substituents.

8. A compound according to any one of the preceding claims wherein Ar² in each occurrence is independently phenyl that is unsubstituted or substituted with one or more substituents, optionally substituted with one or more C₁₋₂₀ alkyl groups.

9. A compound according to any one of the preceding claims wherein q is 1.

10. A compound according to any one of the preceding claims wherein the compound has a photoluminescent spectrum having a peak wavelength in the range of 400-490 nm.

11. A composition comprising a host material and a compound according to any one of the preceding claims.

12. A solution comprising a compound or composition according to any one of the preceding claims dissolved in one or more solvents.

13. An organic light-emitting device comprising an anode, a cathode and a light-emitting layer between the anode and cathode wherein the light-emitting layer comprises a compound or composition according to any one of claims 1-11.

14. An organic light-emitting device according to claim 13 wherein the device emits white light.

15. A method of forming an organic light-emitting device according to claim 13 or 14 comprising the step of depositing the light-emitting layer over one of the anode and cathode, and depositing the other of the anode and cathode over the light-emitting layer, wherein the light-emitting layer is formed by depositing a solution according to claim 12 and evaporating the one or more solvents.

## Patentansprüche

1. Phosphoreszierende Verbindung der Formel (I): 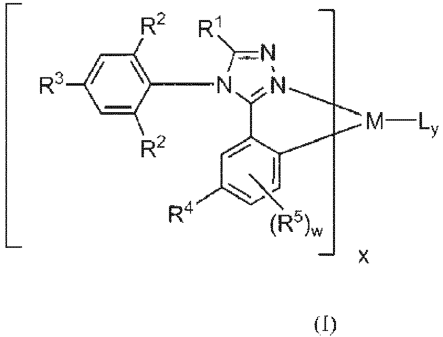 wobei:
M ein Übergangsmetall ist;
L bei jedem Vorkommen unabhängig ein ein- oder mehrzähniger Ligand ist;
R¹ ein C₄₋₂₀-Alkyl umfassend mindestens ein tertiäres Kohlenstoffatom ist;
R² unabhängig bei jedem Vorkommen eine lineare, verzweigte oder cyclische C₁₋₂₀-Alkylgruppe ist;
R³ eine lineare, verzweigte oder cyclische C₁₋₂₀-Alkylgruppe oder eine Gruppe der Formel -(Ar¹)ₚ ist, wobei Ar¹ bei jedem Vorkommen unabhängig eine unsubstituierte oder substituierte Aryl- oder Heteroarylgruppe ist und p mindestens 1 ist;
R⁴ eine Gruppe der Formel -(Ar²)_{q} ist, wobei Ar² bei jedem Vorkommen unabhängig eine unsubstituierte oder substituierte Aryl- oder Heteroarylgruppe ist und q mindestens 1 ist;
R⁵ ein Substituent ist;
w 0 oder eine positive ganze Zahl ist;
x mindestens 1 ist; und
y 0 oder eine positive ganze Zahl ist.

2. Verbindung nach Anspruch 1, wobei M aus Iridium, Platin, Osmium, Palladium, Rhodium und Ruthenium ausgewählt ist.

3. Verbindung nach Anspruch 1 oder 2, wobei y 0 ist.

4. Verbindung nach Anspruch 3, wobei x 3 ist.

5. Verbindung nach einem der vorhergehenden Ansprüche, wobei ein tertiäres Kohlenstoffatom von R¹ direkt an den Triazolring der Formel (I) gebunden ist.

6. Verbindung nach einem der vorhergehenden Ansprüche, wobei w 0 ist.

7. Verbindung nach einem der vorhergehenden Ansprüche, wobei Ar¹ bei jedem Vorkommen unabhängig Phenyl ist, das unsubstituiert oder mit einem oder mehreren Substituenten substituiert ist.

8. Verbindung nach einem der vorhergehenden Ansprüche, wobei Ar² bei jedem Vorkommen unabhängig Phenyl ist, das unsubstituiert oder mit einem oder mehreren Substituenten substituiert, wahlweise mit einer oder mehreren C₁₋₂₀-Alkylgruppen substituiert, ist.

9. Verbindung nach einem der vorhergehenden Ansprüche, wobei q 1 ist.

10. Verbindung nach einem der vorhergehenden Ansprüche, wobei die Verbindung ein photolumineszierendes Spektrum mit einer Spitzenwellenlänge im Bereich von 400-490 nm aufweist.

11. Zusammensetzung umfassend ein Wirtsmaterial und eine Verbindung nach einem der vorhergehenden Ansprüche.

12. Lösung umfassend eine Verbindung oder Zusammensetzung nach einem der vorhergehenden Ansprüche, die in einem oder mehreren Lösungsmitteln gelöst ist.

13. Organische lichtemittierende Vorrichtung umfassend eine Anode, eine Kathode und eine lichtemittierende Schicht zwischen der Anode und Kathode, wobei die lichtemittierende Schicht eine Verbindung oder Zusammensetzung nach einem der Ansprüche 1-11 umfasst.

14. Organische lichtemittierende Vorrichtung nach Anspruch 13, wobei die Vorrichtung weißes Licht emittiert.

15. Verfahren zum Herstellen einer organischen lichtemittierenden Vorrichtung nach Anspruch 13 oder 14, umfassend den Schritt des Ablagerns der lichtemittierenden Schicht über einer der Anode und Kathode und des Ablagerns der anderen der Anode und Kathode über der lichtemittierenden Schicht, wobei die lichtemittierende Schicht durch Ablagern einer Lösung nach Anspruch 12 und Verdampfen des einen oder der mehreren Lösungsmittel hergestellt wird.

## Revendications

1. Composé phosphorescent de formule (I) : 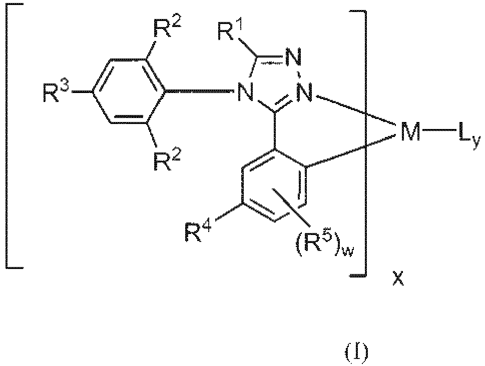 où :
M est un métal de transition ;
L, dans chaque occurrence, est indépendamment un ligand mono ou polydenté ;
R¹ est un alkyle C₄₋₂₀ comprenant au moins un atome de carbone tertiaire ;
R², indépendamment dans chaque occurrence, est un groupe alkyle C₁₋₂₀ linéaire, ramifié ou cyclique ;
R³ est un groupe alkyle C₁₋₂₀ linéaire, ramifié ou cyclique ou un groupe de formule -(Ar¹)ₚ où Ar¹, dans chaque occurrence, est indépendamment un groupe aryle ou hétéroaryle non substitué ou substitué et p est au moins 1 ;
R⁴ est un groupe de formule -(Ar²)_{q} où Ar², dans chaque occurrence, est indépendamment un groupe aryle ou hétéroaryle non substitué ou substitué et q est au moins 1 ;
R⁵ est un substituant ;
w est 0 ou un nombre entier positif ;
X est au moins 1 ; et
y est 0 ou un nombre entier positif.

2. Composé selon la revendication 1, dans lequel M est sélectionné entre : iridium, platine, osmium, palladium, rhodium et ruthénium.

3. Composé selon la revendication 1 ou 2, dans lequel y est 0.

4. Composé selon la revendication 3, dans lequel x est 3.

5. Composé selon l'une quelconque des revendications précédentes, dans lequel un atome de carbone tertiaire de R¹ est lié directement à l'anneau de triazole de la formule (I).

6. Composé selon l'une quelconque des revendications précédentes, dans lequel w est 0.

7. Composé selon l'une quelconque des revendications précédentes, dans lequel Ar¹, dans chaque occurrence, est indépendamment un phényle qui est non substitué ou substitué avec un ou plusieurs substituants.

8. Composé selon l'une quelconque des revendications précédentes, dans lequel Ar² dans chaque occurrence est indépendamment un phényle qui est non substitué ou substitué avec un ou plusieurs substituants, optionnellement substitué avec un ou plusieurs groupes alkyle C₁₋₂₀.

9. Composé selon l'une quelconque des revendications précédentes, dans lequel q est 1.

10. Composé selon l'une quelconque des revendications précédentes, le composé ayant un spectre photoluminescent ayant une longueur d'onde pic dans la gamme de 400-490 nm.

11. Composition comprenant un matériau hôte et un composé selon l'une quelconque des revendications précédentes.

12. Solution comprenant un composé ou une composition selon l'une quelconque des revendications précédentes, dissous dans un ou plusieurs solvants.

13. Dispositif luminescent organique comprenant une anode, une cathode et une couche luminescente entre l'anode et la cathode, dans lequel la couche luminescente comprend un composé ou une composition selon l'une quelconque des revendications 1-11.

14. Dispositif luminescent organique selon la revendication 13, le dispositif émettant une lumière blanche.

15. Procédé de formation d'un dispositif luminescent organique selon la revendication 13 ou 14, comprenant l'étape de dépôt de la couche luminescente par-dessus l'une de l'anode et de la cathode, et le dépôt de l'autre de l'anode et de la cathode par-dessus la couche luminescente, dans lequel la couche luminescente est formée par le dépôt d'une solution selon la revendication 12 et l'évaporation du ou des solvants.
